Europäisches Patentamt

European Patent Office

Office européen des brevets

(11) Veröffentlichungsnummer: **0 362 542**

**A1**

(12) **EUROPÄISCHE PATENTANMELDUNG**

(21) Anmeldenummer: **89115702.6**

(22) Anmeldetag: **25.08.89**

(51) Int. Cl.5: **G01R 23/17**

(30) Priorität: **23.09.88 DE 3832336**

(43) Veröffentlichungstag der Anmeldung:
**11.04.90 Patentblatt 90/15**

(84) Benannte Vertragsstaaten:
**FR GB IT**

(71) Anmelder: **DEUTSCHE FORSCHUNGSANSTALT FÜR LUFT- UND RAUMFAHRT e.V.**

**D-5300 Bonn(DE)**

(72) Erfinder: **Büteflsch, Karl Aloys, Dr. Dipl.-Phys.**
**Hirtenweg 5**
**D-3406 Bovenden(DE)**
Erfinder: **Kompenhans, Jürgen, Dr. Dipl.-Phys.**
**Am Weinberg 4**
**D-3407 Gleichen(DE)**

(74) Vertreter: **Rehberg, Elmar, Dipl.-Ing.**
**Postfach 3162 Am Kirschberge 22**
**D-3400 Göttingen(DE)**

(54) Verfahren und Vorrichtung zur Auswertung von Zeitsignalen mit periodischen Anteilen oder Pulsfolgen.

(57) Bei dem Verfahren zur Auswertung von Zeitsignalen mit periodischen Anteilen oder Pulsfolgen, wird das Zeitsignal abschnittsweise digitalisiert, auf einem mit kohärentem Licht durchstrahlten Lichtmodulator dargestellt, in einer Fourierebene fokussiert und das Bild in der Fourierebene, das die Frequenz des Zeitsignals enthält, weiterverarbeitet. Der erste Abschnitt des digitalisierten Zeitsignals wird in eine Zeile des Lichtmodulators (6) geschrieben. Jeder weitere Abschnitt wird in einer weiteren Zeile dargestellt. Die Vorrichtung zur Durchführung des Verfahrens weist eine Digitalisierungsvorrichtung (3) und einen ein abschnittsweise digitalisiertes Zeitsignal auf dem Lichtmodulator darstellenden Controller (5) auf. Der Lichtmodulator wird von kohärentem Licht einer Lichtquelle (8) durchleuchtet. Von einer Optik (9) wird das Licht auf einem in der Fourierebene angeordneten Bildschirm (11) fokussiert. Als Controller ist ein Zeilencontroller vorgesehen.

Fig. 1

## Verfahren und Vorrichtung zur Auswertung von Zeitsignalen mit periodischen Anteilen oder Pulsfolgen

Die Erfindung geht aus von einem Verfahren zur Auswertung von Zeitsignalen mit periodischen Anteilen oder Pulsfolgen, bei dem das Zeitsignal abschnittsweise digitalisiert, auf einem mit kohärentem Licht durchstrahlten Lichtmodulator dargestellt, in einer Fourierebene fokussiert und das Bild in der Fourierebene, das die Frequenz des Zeitsignals enthält, weiterverarbeitet wird. Die Erfindung zeigt gleichzeitig eine Vorrichtung zur Durchführung des Verfahrens mit einer Digitalisierungsvorrichtung und einem ein abschnittsweise digitalisiertes Zeitsignal auf einem Lichtmodulator darstellenden Controller, wobei der Lichtmodulator von kohärentem Licht einer Lichtquelle durchleuchtet wird und mit einer das Licht auf einem in der Fourierebene angeordneten Bildschirm fokussierenden Optik.

Zeitsignale mit periodischen Anteilen, z. B. sinusförmigen Anteilen oder Pulsfolgen, treten bei technischen Anwendungen häufig auf, so beispielsweise bei der Nachrichtenübertragung, bei Abstandsmessungen mit Radar oder Echo, in der Strukturdynamik, bei der Geschwindigkeitsmessung mit Hilfe der Laser-Doppler-Anemometrie oder mit dem Laser-2-Fokus-Verfahren sowie bei der Laufzeitmessung mittels Ultraschallverfahren. Aus den Zeitsignalen wird dann eine ggf. vorhandene Grundfrequenz bzw. ein Pulsabstand bestimmt, mit deren Hilfe dann letztendlich die gesuchte Größe ermittelt werden kann.

Ein Verfahren der eingangs beschriebenen Art ist bekannt. Das Zeitsignal wird, entsprechend den verfügbaren Reihen des Lichtmodulators in einzelne Abschnitte eingeteilt und digitalisiert. Dieser Abschnitt des digitalisierten Zeitsignals wird dann auf dem Lichtmodulator dargestellt, indem die einzelnen Elemente des Lichtmodulators auf lichtdurchlässig bzw. nicht lichtdurchlässig geschaltet werden. Dieser Lichtmodulator wird dann mit kohärentem Licht durchstrahlt und das Licht in der Fourierebene fokussiert. In der Fourierebene ergibt sich dann das fouriertransformierte Bild, also ein Punktemuster, wobei der Abstand der zu einem mittleren Punkt benachbarten Punkte proportional der Frequenz des Zeitsignals ist. Vorteilhaft an diesem bekannten Verfahren ist, daß das fouriertransformierte Bild des Abschnitts des Zeitsignals quasi ohne Verzögerung dargestellt wird. Damit ist eine sehr schnelle Auswertung möglich. Nachteilig ist jedoch, daß das Zeitsignal nur abschnittsweise auf dem Lichtmodulator dargestellt werden kann, da dieser nur eine endliche Zahl von Spalten aufweist. Dadurch bedingt treten bei länger andauernden und hochfrequenten Zeitsignalen Totzeiten auf, d. h. also, daß nicht das gesamte Zeitsignal ausgewertet werden kann. Diese Totzeiten sind damit zu erklären, daß nach jedem abschnittsweise dargestellten Zeitsignal erst einmal ausgewertet werden muß, um anschließend auf dem Lichtmodulator einen neuen Abschnitt des Zeitsignals darstellen zu können. Das in dieser Zeit ankommende Zeitsignal geht verloren. Weiterhin nachteilig ist, daß mit diesem bekannten Verfahren keine Auswertung von langen Zeitsignalen möglich ist, um ein gemitteltes Ergebnis zu erhalten. Auch eine gleichzeitige Auswertung von Zeitsignalen, die von unterschiedlichen Signalquellen stammen, wie dies beispielsweise bei Standschwingungsversuchen mit unterschiedlichen Schwingungsaufnehmern der Fall ist, ist auf optischem Wege nicht möglich. Um solch einen Mittelwert zu erhalten, ist es erforderlich, die Mittelung später in einem ggf. angeschlossenen Rechner durchzuführen. Die zeitgleiche Auswertung mehrerer Zeitsignale ist nicht möglich. Auch die gleichzeitige Erfassung und Darstellung der Frequenzen von mehreren Zeitsignalen ist nicht möglich.

Es ist weiterhin bekannt, die Zeitsignale mit einem FFT-Analysator auszuwerten. In solch einem käuflich erhältlichen FFT-Analysator wird die Fast-Fourier-Transformation des Zeitsignals durchgeführt. Nachteilig ist, daß solche FFT-Analysatoren mit einer begrenzten Stützstellenzahl, üblicherweise bei nicht zu schnellen Geräten etwa 512, bei schnellen ca. 64, auskommen müssen, so daß bei großem Rauschen, d. h. geringem Signal-/Rauschabstand, die Grundfrequenz nicht mehr erkennbar ist. Weiterhin nachteilig ist die Rechenzeit relativ lang. Auch bei diesen FFT-Analysatoren treten bei hochfrequenten Signalen zwischen den einzelnen Abschnitten des Zeitsignals Abschnitte auf, die nicht erfaßt werden. Die Totzeit ergibt sich hauptsächlich aus der Zeit, die der Rechner für die Auswertung bzw. für die FFT-Analyse benötigt. Es besteht natürlich die Möglichkeit, durch Verwendung mehrerer FFT-Analysatoren diese Totzeit weitgehend auszuschalten, dies bedeutet jedoch einen erheblichen Aufwand. Weiterhin sind solche FFT-Analysatoren relativ teuer, so daß schon deshalb zumeist auf die Verwendung mehrerer FFT-Analysatoren verzichtet werden muß.

Der Erfindung liegt die Aufgabe zugrunde, ein Verfahren und eine Vorrichtung zur Auswertung von Zeitsignalen mit periodischen Anteilen und Pulsfolgen der eingangs beschriebenen Art so weiterzubilden, daß auch lange Zeitsignale oder simultan viele Signale unter Fortfall einer Totzeit ausgewertet werden können. Weiterhin soll das Verfahren auch bei geringem Signal-/Rauschabstand noch zuverlässige Ergebnisse liefern.

Erfindungsgemäß wird dies dadurch erreicht, daß der erste Abschnitt des digitalisierten Zeitsignals in eine Zeile des Lichtmodulators geschrieben wird, und daß jeder weitere Abschnitt in einer weiteren Zeile dargestellt wird. Das Verfahren beruht auf einer optischen Fourier-Analyse. Das Zeitsignal wird in einzelne Abschnitte unterteilt und diese Abschnitte werden digitalisiert. Die Länge der einzelnen Abschnitte ist abhängig von der Anzahl der Spalten des verwendeten Lichtmodulators. Der erste Abschnitt des digitalisierten Zeitsignals wird nun in die erste Zeile des Lichtmodulators geschrieben, der Lichtmodulator wird also nicht, wie im Stand der Technik bekannt, mit einem Abschnitt des Zeitsignals bereits vollständig gefüllt, sondern es wird lediglich eine einzige Zeile des eine Vielzahl von Zeilen aufweisenden Lichtmodulators gefüllt. Die folgenden Abschnitte des Zeitsignals werden dann in die jeweilige Zeile des Lichtmodulators geschrieben. Der Lichtmodulator wird dann mit kohärentem Licht durchleuchtet und das Licht wird in der Fourierebene fokussiert. In der Fourierebene ergibt sich dann ein Punktemuster, wobei der Abstand der zu einem mittleren Punkt benachbarten Punkte proportional der Frequenz des Zeitsignals ist. Aus dieser Frequenz läßt sich dann die gesuchte Größe bestimmen, beispielsweise also die Geschwindigkeit. Besonders hervorzuheben ist, daß hier nicht nur ein einzelner Abschnitt des Zeitsignals ausgewertet wird, sondern daß gleichzeitig eine Vielzahl von Abschnitten ausgewertet werden. In der Fourierebene erhält man dann den Mittelwert der Frequenzen der einzelnen Abschnitte, also die Grundfrequenz des Zeitsignals. Auch bei langen Zeitsignalen treten Totzeiten nicht auf, da der Lichtmodulator kontinuierlich vollgeschrieben werden kann. Man erhält somit die Möglichkeit, quasi zeitgleich mit dem Entstehen der Zeitsignale diese auszuwerten. Die Messungen können also direkt überwacht werden, was beispielsweise bei strukturdynamischen Untersuchungen besonders wichtig ist. Schädliche Frequenzen oder Pulsabstände werden sofort erkannt und der Versuch kann abgebrochen werden. Aber auch bei anderen Versuchen, beispielsweise bei der Geschwindigkeitsmessung auf der Grundlage der Laser-Doppler-Anemometrie ist es von Vorteil, ohne nennenswerte Zeitverschiebung die Meßergebnisse direkt angezeigt zu bekommen. Unregelmäßigkeiten können sofort erkannt und abgestellt werden. Auch ist dieses Verfahren relativ preiswert zu realisieren, teure schnellarbeitende Prozessoren o. dgl sind nicht erforderlich.

Auch lang andauernde Zeitsignale können ohne Totzeit ausgewertet werden. Ist der Lichtmodulator vollgeschrieben, d. h. sind alle Zeilen des Lichtmodulators besetzt, so kann, beginnend mit der ersten Zeile, der Schreibvorgang fortgesetzt und damit die Zeilen des Lichtmodulators überschrieben werden. Es findet mithin ein fortlaufendes Einlesen in den Lichtmodulator statt. Das in der Fourierebene dargestellte fouriertransformierte Bild, also das Punktemuster, erhält dann stets die Grundfrequenz der auf dem Lichtmodulator dargestellten Abschnitte des Zeitsignals. Es besteht somit die Möglichkeit, Veränderungen der Grundfrequenz (z. B. durch turbulente Geschwindigkeitsschwankungen beim LDA) durch eine entsprechende Veränderung des fouriertransformierten Bilds direkt abzulesen.

Es können mehrere von jeweils verschiedenen Signalquellen stammende Zeitsignale in verschiedenen Zeilen des Lichtmodulators eingelesen werden. Die Zeitsignale können dabei aus beispielsweise verschiedenen Meßaufnehmern stammen und sich über ein oder mehrere Abschnitte erstrekken. Diese Einzelabschnitte werden dann jeweils in eine oder mehrere Zeilen, abhängig von der Länge des Zeitsignals, in den Lichtmodulator eingelesen. Das fouriertransformierte Bild gibt dann den Mittelwert der Einzelspektren wieder.

Zur Digitalisierung des Zeitsignals kann ein Schwellwert vorgegeben werden, wobei beim Überschreiten des Schwellwerts das Zeitsignal eine erste Amplitudenstufe und beim Unterschreiten eine zweite Amplitudenstufe aufweist. Das Zeitsignal wird also derart digitalisiert, daß nur zwei Amplitudenstufen auftreten, die dann in dem Lichtmodulator als licht durchlässig bzw. nicht lichtdurchlässig dargestellt werden. Man spricht dann von einem geklippten Zeitsignal. Überschreitet die Amplitude des zu digitalisierenden Zeitsignals den Schwellwert, so wird das digitalisierte Zeitsignal auf beispielsweise Eins gesetzt, unterschreitet es dagegen den Schwellwert, so wird es auf Null gesetzt. Das digitalisierte Zeitsignal stellt sich dann auf der Zeitachse als ein binäres Signal mit den Werten Null und Eins dar. Bei beispielsweise einer Sinusschwingung würde der ersten Halbperiode der Wert Eins zugeordnet, der zweiten Halbperiode der Wert Null. Der Schwellwert ist abhängig von dem jeweiligen Problem und entsprechend einzustellen. Diese Art der Digitalisierung ist dann durchzuführen, wenn der verwendete Lichtmodulator binär ist, d. h. wenn sich auf dem Lichtmodulator keine Graustufen darstellen lassen. Das Zeitsignal wird durch diese Digitalisierung auf die benötigte Information, d. h. auf die Frequenz reduziert. Da jedoch nur diese Frequenz gesucht ist, reicht im allgemeinen diese Darstellungsform voll aus. Eine aufwendige, langsame Digitalisierungsvorrichtung entfällt in diesem Fall. Damit wird eine hohe Digitalisierungsgeschwindigkeit erreicht, so daß auch sehr hohe Frequenzen einer Untersuchung hinsichtlich einer Grundfrequenz zugänglich werden. Kann dagegen der verwendete Lichtmodulator Graustufen darstellen, so wird das Zeitsignal in genauso viele Amplitudenstufen diskretisiert, wie der Lichtmodulator Graustufen verarbeiten kann. In beiden Fällen kann dann das Zeitsignal abschnittsweise in eine einzige Zeile des Lichtmodulators geschrieben werden.

Wie oben bereits erwähnt, ergibt sich in der Fourierebene ein Punktemuster, d. h. das fouriertransformierte Bild, wobei der Abstand der einzelnen Punkte proportional der Frequenz des Zeitsignals ist. Im Normalfall wird der Abstand der beiden zu dem mittleren Punkt benachbarten Punkte erfaßt und entsprechend weiterverarbeitet. Bei einigen Untersuchungen reicht es jedoch aus, wenn eine Änderung der Frequenz des Zeitsignals registriert wird. In diesem Fall ist es zweckmäßig, nur den einen Ort zu beobachten, der der zu überwachenden Frequenz entspricht. Ändert sich die Grundfrequenz des Zeitsignals gegenüber der vorgegebenen Frequenz, so wandert der eine Punkt des Punktemessers aus dem zu beobachtenden Ort hinaus. Damit ist eine sichere Überwachung einer vorgegebenen Grundfrequenz möglich.

Das Zeitsignal und/oder das in der Fourierebene fokussierte fouriertransformierte Zeitsignal kann gespeichert werden. Das gespeicherte Zeitsignal und/oder das fouriertransformierte Zeitsignal dient dann für ggf. später anzustellende Vergleiche. Auch ist es so möglich, die Grundfrequenz von zu verschiedenen Zeitpunkten auftretenden Zeitsignalen zu ermitteln, indem die verschiedenen Zeitsignale auf dem Lichtmodulator dargestellt und entsprechend ausgewertet werden.

Die Vorrichtung zur Durchführung des Verfahrens kennzeichnet sich dadurch, daß als Controller ein Zeilencontroller vorgesehen ist. Der Zeilencontroller ist also derart ausgebildet und angeordnet, daß er das digitalisierte Zeitsignal zeilenweise in den Lichtmodulator schreibt. Vorteilhaft können weiterhin mehrere Digitalisierungsvorrichtungen vorgesehen sein, wobei eine Scanneinrichtung angeordnet ist, die die digitalisierten Zeitsignale verschiedenen Zeilencontrollern und verschiedenen Lichtmodulatoren zuleitet. Dies ist insbesondere dann sinnvoll, wenn extrem lange Zeitsignale mit hoher Frequenz vorliegen, so daß eine einzelne Digitalisierungsvorrichtung das Zeitsignal nicht mehr kontinuierlich verarbeiten kann. In solch einem Fall können dann mehrere Digitalisierungsvorrichtungen vorgesehen sein, die abwechselnd das Zeitsignal digitalisieren und die über die Scanneinrichtung dann mit dem Zeilencontroller des Lichtmodulators verbunden sind.

Die Optik kann derart ausgebildet und angeordnet sein, daß sie alle Zeilen des Lichtmodulators und/oder einzelne ausgesuchte Zeilen auf dem Bildschirm darstellt. Es besteht somit die Möglichkeit, neben der Mittelung über alle auf dem Lichtmodulator dargestellten Einzelspektren nur eine zeilenweise Mittelung vorzunehmen. In der Fourierebene wird dann das jeder Zeile entsprechende fouriertransformierte Bild dargestellt, entweder für jede Zeile nacheinander oder aber zeitgleich zeilenweise angeordnet.

Die Erfindung wird anhand von bevorzugten Ausführungsbeispielen weiter beschrieben. Es zeigen:

Figur 1 einen Aufbau zur Durchführung des Verfahrens in schematisierter Weise,

Figur 2 ein verrauschtes Zeitsignal,

Figur 3 ein stark verrauschtes Zeitsignal,

Figur 4 eine schematische Darstellung eines Zeitsignals,

Figur 5 ein erste Möglichkeit zur Digitalisierung des Zeitsignals,

Figur 6 eine zweite Möglichkeit zur Digitalisierung des Zeitsignals,

Figur 7 eine schematische Darstellung eines Lichtmodulators und

Figur 8 ein sich in der Fourierebene ergebendes Punktemuster.

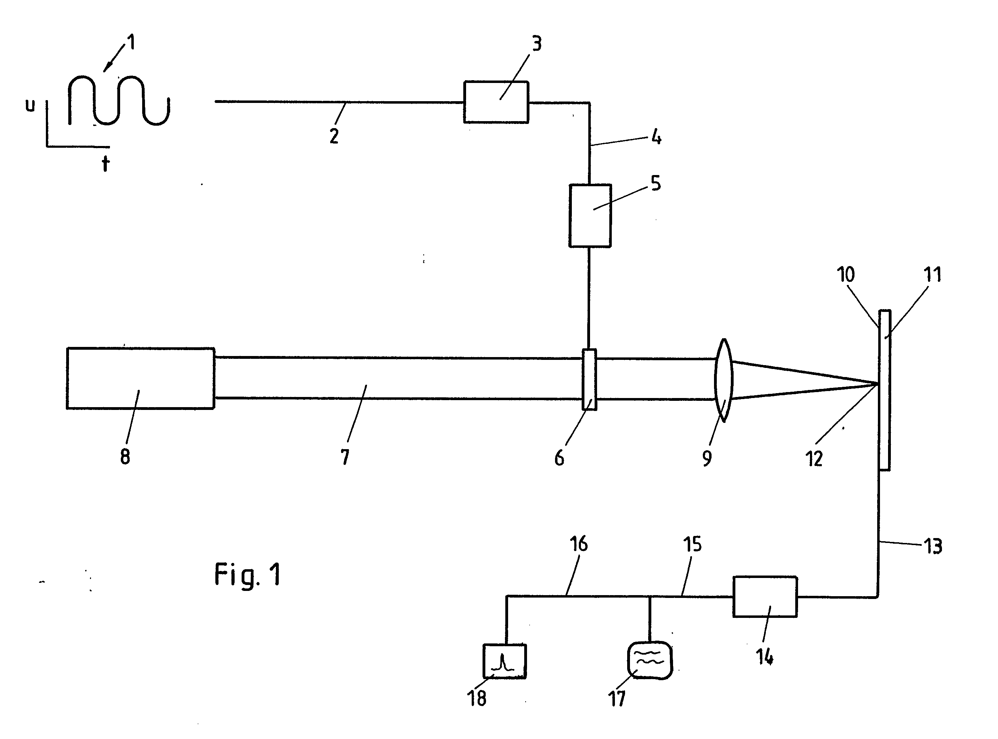

In Figur 1 ist in schematisierter Weise eine Vorrichtung zur Durchführung des erfindungsgemäßen Verfahrens dargestellt. Ein Zeitsignal 1, welches von einer hier nicht weiter dargestellten Meßeinrichtung o. dgl. geliefert wird, wird über eine Leitung 2 einer Digitalisierungsvorrichtung 23 zugeführt. In der Digitalisierungsvorrichtung 3 wird das Zeitsignal 1, wie später beschrieben, digitalisiert und anschließend über eine Leitung 4 zu einem Zeilencontroller 5 weitergeleitet. Der Zeilencontroller 5 steuert einen Lichtmodulator 6 derart, daß das digitalisierte Zeitsignal 1 in eine Zeile des Lichtmodulators 6 geschrieben wird. Eine kohärentes Licht 7 emittierende Lichtquelle 8 ist derart angeordnet, daß das kohärente Licht 7 den Lichtmodulator 6 durchstrahlt. Hinter dem Lichtmodulator 6 ist eine Optik 9 vorgesehen, die das kohärente Licht 7 in einer Fourierebene 10 fokussiert. In der Fourierebene 10 ist ein Bildschirm 11 angeordnet, der als Zeilenkamera o. dgl. ausgebildet sein kann. Auf dem Bildschirm 11 wird ein fouriertransformiertes Bild 12 des Zeitsignals ausgebildet. Der Bildschirm 11 steht über eine Leitung 13 mit einem Rechner 14 in Verbindung, auf dem die weitergehende Auswertung durchgeführt wird. Das Ergebnis wird dann über Leitungen 15 und 16 an Ausgabegeräte 17 und 18 weitergeleitet und auf den Ausgabegeräten 17 und 18 dargestellt. Die Ausgabegeräte 17 und 18 können beispielsweise ein Terminal oder ein Plotter sein.

Im Folgenden soll nun die Funktionsweise näher erläutert werden. Das Zeitsignal 1 wird von einer Meßeinrichtung o. dgl. zur Verfügung gestellt und soll hinsichtlich seiner Grundfrequenz untersucht werden. Durch unerwünschte Störungen wie Rauschen o. dgl. erhält man Zeitsignale 19 bwz.

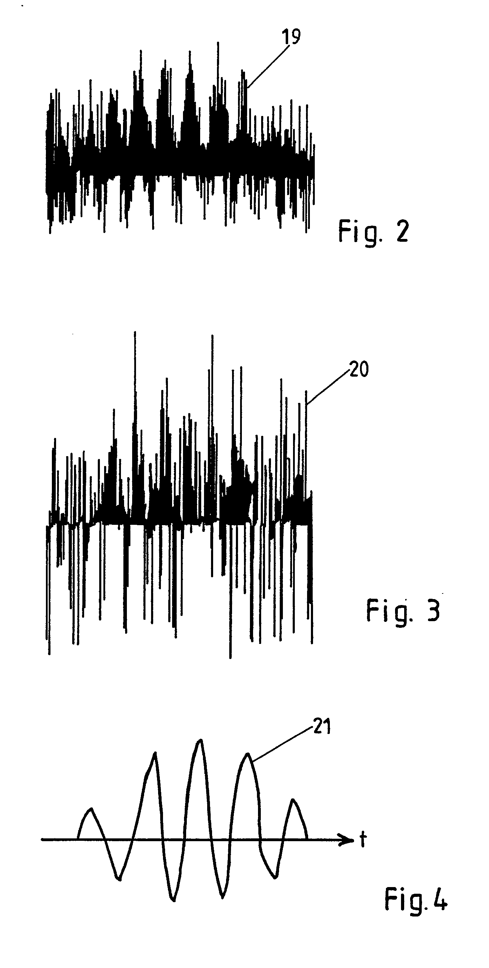

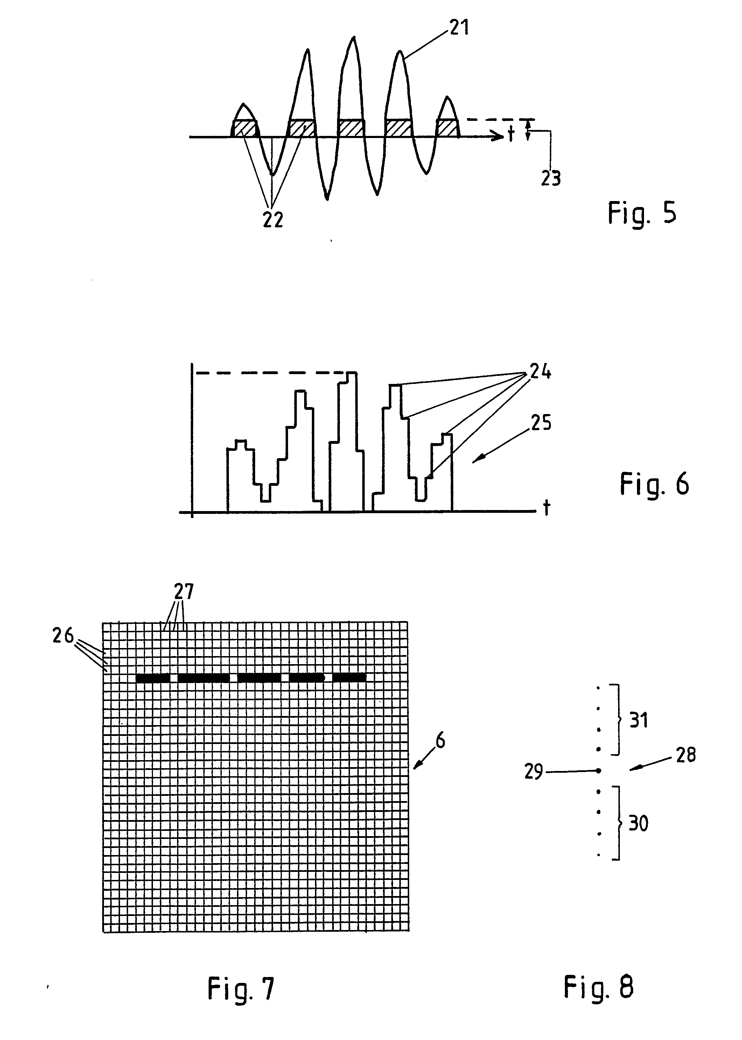

20, siehe Figuren 2 und 3, bei denen die Frequenz nicht ohne Weiteres ersichtlich ist. Die in den Figuren 2 und 3 dargestellten Zeitsignale 19 und 20 bilden nur einen Abschnitt des tatsächlich vorhandenen Zeitsignals, welches über der Zeit gesehen wesentlich länger andauert. Das Zeitsignal 19, 20 wird über die Leitung 2 der Digitalisierungsvorrichtung 3 zugeführt. Um die Arbeitsweise der Digitalisierungsvorrichtung 3 besser erläutern zu können, wird ein Zeitsignal 21, siehe Figur 4, angenommen, welches keinerlei Störanteile aufweist. Im einfachsten Fall wird das Zeitsignal 21 geklippt, so daß das digitalisierte Zeitsignal 22 lediglich zwei Amplitudenstufen aufweist, wie es in Figur 5 dargestellt ist. Dafür wird ein Schwellwert der Amplitude 23 vorgegeben, der, abhängig von dem jeweils vorliegenden Problem, festgelegt wird. Ist die Amplitude des Zeitsignals 21 größer als der Schwellwert 23, so wird das digitalisierte Zeitsignal 22 auf beispielsweise Eins gesetzt, ist die Amplitude des Zeitsignals 21 kleiner als der Schwellwert 23, so ergibt sich das digitalisierte Zeitsignal 22 zu Null. Das Zeitsignal 21 wird mithin binär dargestellt. Eine weitere Möglichkeit zur Digitalisierung des Zeitsignals 21 ist in Figur 6 dargestellt. Hier wird das Zeitsignal 21 nicht mehr binär gezeigt, sondern ist in eine Vielzahl von Amplitudenstufen 24 aufgeteilt. Ein derart erhaltenes digitalisiertes Zeitsignal 25 hat den Vorteil, daß es, im Gegensatz zu dem binären digitalisierten Zeitsignal 22, noch mehr Informationen über die Amplitude des Zeitsignals 21 aufweist. Im allgemeinen reicht es aber bereits aus, das Zeitsignal 21 in ein binäres digitalisiertes Zeitsignal 22 umzuwandeln. Die Wahl, ob eine binäre Umwandlung in das digitalisierte Zeitsignal 22 oder eine Umwandlung in das digitalisierte Zeitsignal 25 mit mehreren Amplitudenstufen 24 durchgeführt wird, ist in erster Linie abhängig von dem verwendeten Lichtmodulator 6. Kann der Lichtmodulator 6 nur zwei Zustände, beispielsweise lichtdurchlässig und nicht lichtdurchlässig darstellen, so muß das Zeitsignal 21 in das binäre digitalisierte Zeitsignal 22 umgewandelt werden. Es sind jedoch auch Lichtmodulatoren 6 bekannt, die eine Grauwertdarstellung ermöglichen. Dies heißt, daß jeder Punkt auf dem Lichtmodulator 6 verschiedene Graufärbungen bzw. Graustufen annehmen kann. In Abhängigkeit der Anzahl der Graustufen des verfügbaren Lichtmodulators 6 werden dann die Amplitudenstufen 24 bestimmt und das Zeitsignal 21 entsprechend digitalisiert. Der Zeilencontroller 5, dem das digitalisierte Zeitsignal 22 bzw. 25 zugeführt wird, sorgt für die Ansteuerung des Lichtmodulators 6 entsprechend dem digitalisierten Zeitsignal 22 bzw. 25. In Figur 7 ist der Lichtmodulator 6 stark schematisiert dargestellt. Der Lichtmodulator 7 ist in Zeilen 26 und Spalten 27 eingeteilt. Dadurch ergibt sich die hier eingezeichnete, in der Realität natürlich nicht derart auftretende Rasterung. Jeder Punkt des Lichtmodulators 6 ist durch Angabe der bestimmten Zeile 26 und der Spalte 27 eindeutig definiert und kann durch den Zeilencontroller 5 angesteuert werden. Der Zeilencontroller 5 steuert den Lichtmodulator nun derart an, daß das digitalisierte Zeitsignal 22 bzw. 25 in eine Zeile 26 des Lichtmodulators 6 geschrieben wird. In der Figur 7 ist solch eine vollgeschriebene Zeile dargestellt. Normalerweise wird natürlich, bei leerem Lichtmodulator 6, das digitalisierte Zeitsignal 22 bzw. 25 in die erste Zeile 26 und beginnend bei der ersten Spalte 27 eingelesen werden. Es ist aber auch möglich, bei der letzten Zeile 26 und der letzten Spalte 27 zu beginnen. Das Zeitsignal 21, so wie es in Figur 4 dargestellt ist, entspricht nur einem Abschnitt des eigentlichen Zeitsignals, welches sich über eine längere Zeit erstreckt. Nachdem der erste Abschnitt in die erste Zeile des Lichtmodulators geschrieben worden ist, werden die folgenden Abschnitte in die jeweils nächstfolgenden Zeilen des Lichtmodulators geschrieben. Wenn alle Zeilen vollgeschrieben sind, werden mit der ersten Zeile beginnend nacheinander die Zeilen wieder überschrieben. Es ist auch anders möglich: Nachdem der erste Abschnitt in den Lichtmodulator eingelesen worden ist, wird der nächste Abschnitt auf dem Lichtmodulator 6 dargestellt, bis die jeweilige Zeile 26 vollgeschrieben ist. Bei Beginn in der ersten Zeile 26 und in der ersten Spalte 27 wird dann die vollgeschriebene Zeile 26 nach unten verschoben, so daß neue Abschnitte des Zeitsignals 21 nunmehr wiederum in die erste Zeile 26 eingelesen werden können. Dieser Vorgang findet kontinuierlich statt. Es versteht sich, daß die Digitalisierungsvorrichtung 3 und der Zeilencontroller der jeweiligen Schreibprozedur entsprechend angepaßt sind. In dem Fall, daß die Digitalisierungsvorrichtung 3 oder der Zeilencontroller 5 nicht mit der benötigten Frequenz arbeiten können, können auch mehrere dieser Geräte vorgesehen sein, die dann über eine entsprechende, hier nicht dargestellte Scanneinrichtung angesteuert werden. Es ist somit möglich, ohne Totzeit, d. h. also ohne Verlust von abschnittweisen Informationen des Zeitsignals 21 auch bei langen Zeitsignalen 21 dieses auf dem Lichtmodulator 6 darzustellen. Es wäre auch denkbar, daß nicht nur ein Zeitsignal 21, sondern eine Vielzahl von Zeitsignalen, die von unterschiedlichen Signalquellen herrühren, gleichzeitig bzw. quasi gleichzeitig auf dem Lichtmodulator 6 dargestellt werden. In der Fourierebene 10 ergibt sich dann mittels der Optik 9 der Mittelwert der Frequenzen der auf dem Lichtmodulator 6 dargestellten Zeitsignale. Die Mittelung, also die gemittelte Grundfrequenz, ergibt sich automatisch, Rechenoperationen o. dgl. sind nicht mehr erforderlich. Es versteht sich, daß der Lichtmodulator 6 nicht in allen Fällen unbedingt vollgeschrieben werden muß, sondern daß auch Spalten 27 und Zeilen 26 leer bleiben können, wenn nur eine begrenzte Anzahl von Zeitsignalen 21 bzw. ein nur relativ kurzes Zeitsignal 21 ausgewertet werden soll. Bei einem kontinuierlichen Vollschreiben des Lichtmodulators 6 mit entsprechendem zyklischen Beschreiben der Zeilen 26 erhält man aus dem fouriertransformiertem Bild 12 die Information über ggf. eine Änderung der Grundfrequenz.

Das mit der Optik 9 erhaltene fouriertransformierte Bild 12 besteht dann aus einem Punktemuster 28, welches einen mittleren Punkt 29 und benachbarte Punkte 30 und 31 aufweist (Figur 8). Der Abstand der benachbarten Punkte 30 und 31 ist direkt proportional der mittleren Frequenz der auf dem Lichtmodulator 6 dargestellten Zeitsignale 21. Liegt keine mittlere Frequenz, also keine Grundfrequenz der auf dem Lichtmodulator 6 dargestellten Zeitsignale vor, so stellt sich das fouriertransformierte Bild 12 als diffuser Lichtfleck dar. Das Punktmuster 28 bzw. der diffuse Lichtfleck bei Fehlen einer gemeinsamen Grundfrequenz wird auf dem Bildschirm 11 aufgenommen. Der Bildschirm 11 kann als Zeilenkamera o. dgl. ausgebildet sein, es ist aber auch möglich, daß, zur Überwachung einer fest vorgegebenen Grundfrequenz, lediglich eine Fotozelle Verwendung findet. Die Signale von dem Bildschirm 11 werden dann dem Rechner 12 zugeführt, der aus dem Abstand des Punktemusters 28 bzw. aus dem Abstand zwischen den benachbarten Punkten 30 und 31 zu dem mittleren Punkt 29 die Frequenz des Zeitsignals 21 und daraus die ggf. noch weiter gesuchten Größen wie Geschwindigkeit o. dgl. berechnet. Aus der geometrischen Form der Punkte (Kreis, Oval) lassen sich Aussagen über Schwankungen der Grundfrequenz machen. Bei Verwendung einer entsprechend modifizierten Optik 9 erscheinen die zu den Zeilen gehörenden Einzelspektren in Form der Punktemuster wie Figur 8, aber entsrechend der Zeilenzahl als untereinander angeordnete Zeilenmuster, also nicht alle auf eine Linie fokussiert. In diesem Fall wird der Bildschirm 11 als flächenhafte Videokamera o. dgl. ausgebildet. Die Ergebnisse werden dann auf den Ausgabegeräten 17 und 18 dargestellt, so daß eine kontinuierliche Überwachung möglich ist.

Bezugszeichenliste:

1 = Zeitsignal
2 = Leitung
3 = Digitalisierungsvorrichtung
4 = Leitung
5 = Zeilencontroller
6 = Lichtmodulator
7 = kohärentes Licht
8 = Lichtquelle
9 = Optik
10 = Fourierebene
11 = Bildschirm
12 = fouriertransformiertes Bild
13 = Leitung
14 = Rechner
15 = Leitung
16 = Leitung
17 = Ausgabegerät
18 = Ausgabegerät
19 = Zeitsignal
20 = Zeitsignal
21 = Zeitsignal
22 = digitalisiertes Zeitsignal
23 = Schwellwert
24 = Amplitudenstufe
25 = digitalisiertes Zeitsignal
26 = Zeile
27 = Spalte
28 = Punktemuster
29 = mittlerer Punkt
30 = benachbarter Punkt
31 = benachbarter Punkt

**Ansprüche**

1. Verfahren zur Auswertung von Zeitsignalen mit periodischen Anteilen oder Pulsfolgen, bei dem das Zeitsignal abschnittweise digitalisiert, auf einem mit kohärentem Licht durchstrahlten Lichtmodulator dargestellt, in einer Fourierebene fokussiert und das Bild in der Fourierebene, das die Frequenz des Zeitsignals enthält, weiterverarbeitet wird, dadurch gekennzeichnet, daß der erste Abschnitt des digitalisierten Zeitsignals (22, 25) in eine Zeile (26) des Lichtmodulators (6) geschrieben wird, und daß jeder weitere Abschnitt in einer weiteren Zeile (26) dargestellt wird.

2. Verfahren nach Anspruch 1, dadurch gekennzeichnet, daß bei vollgeschriebenem Lichtmodulator (6) beginnend mit der ersten Zeile (26) der Schreibvorgang fortgesetzt und damit die Zeilen des Lichtmodulators (6) überschrieben werden.

3. Verfahren nach Anspruch 1 oder 2, dadurch gekennzeichnet, daß mehrere von jeweils verschiedenen Signalquellen stammende Zeitsignale (19, 20) in verschiedene Zeilen (26) des Lichtmodulatos (6) eingelesen werden.

4. Verfahren nach einem oder mehreren der Ansprüche 1 bis 3, dadurch gekennzeichnet, daß zur Digitalisierung des Zeitsignals (19, 20) ein Schwellwert (23) vorgegeben wird, und daß beim Überschreiten des Schwellwerts (23) das Zeitsignal (22, 25) eine erste Amplitudenstufe (24) und beim Unterschreiten eine zweite Amplitudenstufe (24) aufweist und somit einer Digitalisierung des Zeitsignals in zwei Amplitudenstufen (Binärstufen) entspricht.

5. Verfahren nach einem oder mehreren der Ansprüche 1 bis 3, dadurch gekennzeichnet, daß das Zeitsignal (19, 20) in eine Vielzahl von Amplitudenstufen (24) digitalisiert wird.

6. Verfahren nach einem oder mehreren der Ansprüche 1 bis 5, dadurch gekennzeichnet, daß zur Überwachung einer vorgegebenen Grundfrequenz des Zeitsignals (19, 20) nur der der Grundfrequenz in der Fourierebene (10) entsprechend Ort beobachtet wird.

7. Verfahren nach einem oder mehreren der Ansprüche 1 bis 6, dadurch gekennzeichnet, daß das Zeitsignal (19, 20) und/oder das in der Fourierebene (10) fokussierte fouriertransformierte Zeitsignal gespeichert wird.

8. Vorrichtung zur Durchführung des Verfahrens nach Anspruch 1, mit einer Digitalisierungsvorrichtung und einem ein abschnittsweise digitalisiertes Zeitsignal auf einem Lichtmodulator darstellenden Controller, wobei der Lichtmodulator von kohärentem Licht einer Lichtquelle durchleuchtet wird und mit einer das Licht auf einem in der Fourierebene angeordneten Bildschirm fokussierenden Optik, dadurch gekennzeichnet, daß als Controller ein Zeilencontroller (5) vorgesehen ist.

9. Vorrichtung nach Anspruch 8, dadurch gekennzeichnet, daß mehrere Digitalisierungsvorrichtungen (3) vorgesehen sind, und daß eine Scanneinrichtung angeordnet ist, die die digitalisierten Zeitsignale (22, 25) verschiedenen Zeilencontrollern (5) und verschiedenen Lichtmodulatoren (6) zuleitet (Parallelbetrieb).

10. Vorrichtung nach Anspruch 8 oder 9, dadurch gekennzeichnet, daß die Optik (9) derart ausgebildet und angeordnet ist, daß sie alle Zeilen (26) des Lichtmodulators (6) und/oder einzelne ausgesuchte Zeilen (26) auf dem Bildschirm (11) darstellt.

Fig. 1

EP 0 362 542 A1

Fig. 2

Fig. 3

Fig. 4

Fig. 5

Fig. 6

Fig. 7

Fig. 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE-A-3 229 308 (P. RUSSER) <br> * Figur 2, Ansprüche 1-4 * <br> --- | 1,8 | G 01 R 23/17 |
| Y | US-A-4 722 596 (J.H. LABRUN et al.) <br> * Figur 1; Zusammenfassung * <br> --- | 1,8 | |
| A | DE-A-3 121 435 (ROCKWELL INTERNATIONAL) <br> * Figur 1; Seiten 3,4 * <br> --- | | |
| A | US-A-3 872 293 (E.L. GREEN) <br> * Figur 1; Zusammenfassung * <br> ----- | | |

**RECHERCHIERTE SACHGEBIETE (Int. Cl.5)**

G 06 G
G 01 R

Der vorliegende Recherchenbericht wurde für alle Patentansprüche erstellt

| Recherchenort | Abschlußdatum der Recherche | Prüfer |
|---|---|---|
| BERLIN | 20-12-1989 | BREUSING J |